# EUROPÄISCHE PATENTANMELDUNG

(11) **EP 0 826 976 A2**
(43) Veröffentlichungstag der Anmeldung: **04.03.1998**
(21) Anmeldenummer: 97202542.3
(22) Anmeldetag: 19.08.1997
(51) Int. Cl.: G01R 33/3415

(54) **MR-Anordnung mit einer Referenzspulen-Anordnung zur Rekonstruktion von MR-Bildern eines Spulen-Arrays**

(30) Priorität: 28.08.1996 DE 19634731
(71) Anmelder: Philips Patentverwaltung GmbH, 22335 Hamburg (DE); Philips Electronics N.V., 5621 BA Eindhoven (NL)
(72) Erfinder: Leussler, Christoph Günther, Röntgenstrasse 24, 22335 Hamburg (DE)
(74) Vertreter: Hartmann, Heinrich, Dipl.-Ing.

(57) **Zusammenfassung**

Die Erfindung betrifft eine MR-Anordnung, bei der mit Hilfe eines Spulen-Arrays ein MR-Bild rekonstruiert werden kann. Die von dem Spulen-Array gelieferten Bilddaten werden mit Hilfe einer Referenzspulen-Anordnung korrigiert, die sich aus einer Anzahl von auf dem Umfang verteilten Spulenelementen zusammensetzt. Damit ist es möglich, mit beiden Spulenanornungen gleichzeitig MR-Signale zu empfangen.

## Beschreibung

Die Erfindung betrifft eine MR-Anordnung umfassend
a) eine Magnetfeldanordnung zur Erzeugung eines homogenen stationären Magnetfeldes in einem Untersuchungsbereich
b) ein Hochfrequenzsystem zur Erzeugung von magnetischen Hochfrequenzimpulsen im Untersuchungsbereich
c) eine Referenzspulen-Anordnung zum Empfang von MR-Signalen aus einem im Untersuchungsbereich befindlichen Objekt
d) eine Verarbeitungseinheit zur Erzeugung von MR-Bildern aus den von den MR-Signalen der Spulenelemente eines Spulen-Arrays abgeleiteten Bilddaten unter Heranziehung von aus den MR-Signalen der Referenzspulen-Anordnung abgeleiteten Referenzdaten.

Eine solche MR-Anordnung ist aus der EP-A-0 695 947 (PHD 94-098) bekannt. Die Spulenelemente des Spulen-Arrays empfangen die MR-Signale aus den spulennahen Bereichen des Untersuchungsobjekts mit einem verbesserten Signal-Rauschverhältnis (im Vergleich zu einer Ganzkörperspule). Als Spulen-Array wird hierbei und im folgenden eine Spulenanordnung bezeichnet, die mehrere Empfangsspulen - meist Oberflächenspulen - umfaßt, deren Signale getrennt voneinander zu einem gemeinsamen MR-Bild verarbeitet werden. Jedoch haben die einzelnen Spulenelemente eine stark ortsabhängige Empfindlichkeit, die zudem noch von der Lage der einzelnen Spulenelemente in bezug auf das Untersuchungsobjekt abhängt (die - ortsabhängige -Empfindlichkeit einer MR-Spule ist definiert als der Quotient aus der magnetischen Induktion an einem Ort und dem Strom in der Spule, der diese magnetische Induktion an disem Ort hervorruft). Deshalb müssen die von dem Spulen-Array erzeugten Daten korrigiert werden, um die ortsabhängigen Empfindlichkeitsunterschiede auszugleichen.

Diesem Zweck dient bei der bekannten Anordnung die Referenzspulen-Anordnung, deren Empfindlichkeit weitgehend ortsunabhängig und unabhängig von dem im Untersuchungsbereich empfindlichen Objekt ist. Sie ist als bei der bekannten MR-Anordnung als Ganzkörper-Spule ausgebildet. Mit den Referenzdaten, die aus den von der Referenzspulen-Anordnung empfangenen MR-Signalen abgeleitet werden, werden die von den Spulenelementen des Spulen-Arrays gelieferten Bilddaten korrigiert, so daß ein MR-Bild rekonstruiert werden kann, das das Untersuchungsobjekt mit verbessertem Signal-Rauschverhältnis und örtlich homogener Empfindlichkeit abbildet.

Nachteilig bei der bekannten MR-Anordnung ist, daß die Messungen mit dem Spulen-Array einerseits und der Referenzspulen-Anordnung andererseits zeitlich voneinander getrennt werden müssen, weil zwischen diesen beiden Spulenanordnungen eine induktive Kopplung besteht, die das Signal-Rauschverhältnis der empfangenen MR-Signale in erheblichem Maße beeinträchtigt. Dadurch wird die Meßzeit verlängert, innerhalb derer die beiden Spulenanordnungen die MR-Signale erfassen.

Aufgabe der vorliegenden Erfindung ist es, eine MR-Anordnung derart auszugestalten, daß die Referenzspulen-Anordnung und das Spulen-Array die MR-Signale gleichzeitig erfassen können, ohne daß das Signal-Rauschverhältnis wesentlich beeinträchtigt wird.

Diese Aufgabe wird erfindungsgemäß dadurch gelöst, daß die Referenzspulen-Anordnung wenigstens vier Spulenelemente umfaßt, die in einem zur Richtung des homogenen stationären Magnetfeldes senkrechten Querschnitt gegeneinander versetzt um den Untersuchungsbereich gruppiert sind, und daß die Spulenelemente eine solche Größe haben und derart gestaltet sind, daß sich zwischen dem Spulen-Array und der Referenzspulen-Anordnung nur eine geringe induktive Kopplung ergibt.

Bei der Erfindung besteht die Referenzspulen-Anordnung also nicht aus einer einzigen Spule, die den gesamten Untersuchungsbereich umschließt, wie bei der bekannten Anordnung, sondern aus wenigstens vier Spulenelementen, die um den Untersuchungsbereich herum gruppiert sind. Dabei wird die Tatsache ausgenutzt, daß die Kopplung zwischen der Referenzspulen-Anordnung und dem Spulen-Array umso geringer wird, je kleiner die Fläche der Spulenelemente der Referenzspulen-Anordnung ist; eine aus vielen Kleinen Spulenelementen zusammengesetzte Referenzspulen-Anordnung weist nämlich eine geringere induktive Kopplung mit dem Spulen-Array auf als eine Referenzspulen-Anordnung, die aus einer einzigen großen Spule besteht. Außerdem kann die induktive Kopplung durch die Gestaltung der einzelnen Spulenelemente der Referenzspulen-Anordnung, d.h. durch geeignete Wahl des Spulentyps verringert werden.

Eine in dieser Hinsicht geeignete Weiterbildung sieht vor, daß die Spulenelemente des Spulen-Arrays einerseits und der Referenzspulen-Anordnung andererseits so gestaltet sind, daß sie um 90° gegeneinander versetzte Magnetfelder empfangen bzw. erzeugen können. Dadurch kann man auch mit einer geringeren Anzahl von Spulenelementen in der Referenzspulen-Anordnung eine gute Entkopplung zwischen den beiden Spulenanordnungen erreichen. Dabei ist in weiterer Ausgestaltung vorgesehen, daß die Spulenelemente der Referenzspulen-Anordnung vom Butterfly-Typ sind, wobei davon ausgegangen wird, daß die Spulenelemente des Spulen-Arrays Oberflächenspulen sind, die bekanntlich Magnetfelder senkrecht zur Spulenebene erzeugen und empfangen bzw. für solche Magnetfelder empfindlich sind. Spulenelemente vom Butterfly-Typ erzeugen demgegenüber Magnetfelder, die parallel zur Spulenebene verlaufen. Grundsätzlich wäre es auch möglich, das Spulen-Array aus Spulenelementen vom Butterfly-Typ und die Referenspulen-Anordnung aus Oberflächenspulen aufzubauen.

In weiterer Ausgestaltung der Erfindung ist vorgesehen, daß die Spulenelemente der Referenzspulen-Anordnung gleichmäßig verteilt auf der Mantelfläche eines Zylinders angeordnet sind, dessen Achse parallel zur Richtung des Hauptmagnetfeldes verläuft. Eine gleichmäßige Verteilung der Spulenelemente auf der Mantelfläche eines Zylinders ist zwar vorteilhaft, aber nicht in jedem Fall erforderlich. Beispielsweise ist es denkbar, Spulenelemente an einigen Stellen des Zylindermantels wegzulassen oder die Spulenelemente auf anders geformten Flächen anzuordnen.

Grundsätzlich wäre es möglich, die MR-Signale, die von den einzelnen Spulenelementen der Referenzspulen-Anordnung empfangen werden, in getrennten digitalen Kanälen weiterzuverarbeiten, was jedoch einen erheblich Aufwand darstellen würde. Eine Weiterbildung sieht daher vor, daß eine Kombinationsschaltung zur Kombination der von den einzelnen Spulenelementen der Referenzspulen-Anordnung empfangenen MR-Signale vorgesehen ist. Für das Ausgangssignal der (analogen) Kombinationsschaltung ist dann nur ein einziger digitaler Verarbeitungskanal erforderlich. Dabei kann in weiterer Ausgestaltung vorgesehen sein, daß zwischen den Spulenelementen der Referenzspulen-Anordnung und der als Addierschaltung wirksamen Kombinationsschaltung je ein einstellbares Phasendrehglied wirksam ist. Durch eine phasenrichtige Kombination der Ausgangssignale der einzelnen Spulenelemente ergibt sich ein Signal, aus dem sich ein Referenzbild ableiten läßt, wie man es mit einer einzelnen großen Referenz-Spule erhalten würde. Durch die Referenzdaten dieses Bildes können die Bilddaten korrigiert werden, die aus den MR-Signalen der einzelnen Spulenelemente abgeleitet werden.

Eine weitere Ausgestaltung der Erfindung sieht vor, daß die Spulenelemente der Referenzspulen-Anordnung mit je einem Vorverstärker über je eine Transformationsschaltung gekoppelt sind, die so bemessen sind, daß die in den Stromkreis der Spulenelemente transformierte Impedanz größer ist als die Impedanz des Spulenelementes. Dadurch werden die beim Empfang von MR-Signalen in den einzelnen Spulenelementen fließenden Wechselströme reduziert, so daß sich eine geringere Wechselwirkung mit den Spulenelementen insbesondere des Spulen-Arrays ergibt.

Es ist auch möglich, ein MR-Gerät mit einer erfindungsgemäßen Referenzspulen-Anordnung nachzurüsten, wobei ausgegangen wird von einem MR-Gerät mit einer Verarbeitungseinheit zur Erzeugung von MR-Bildern aus den von den MR-Signalen der Spulenelemente eines Spulen-Arrays abgeleiteten Bilddaten unter Heranziehung von aus den MR-Signalen der Referenzspulen-Anordnung abgeleiteten Referenzdaten. Eine solche Referenzspulen-Anordnung ist dadurch gekennzeichnet, daß sie wenigstens vier Spulenelemente umfaßt, die in einem zur Richtung des homogenen stationären Magnetfeldes senkrechten Querschnitt gegeneinander versetzt um den Untersuchungsbereich gruppiert sind, und daß die Spulenelemente eine solche Größe haben und derart gestaltet sind, daß sich zwischen dem Spulen-Array und der Referenzspulen-Anordnung nur eine geringe induktive Kopplung ergibt.

Die Erfindung wird nachstehend anhand der Zeichnungen naher erläutert. Es zeigen
- Fig. 1: das Blockschaltbild einer MR-Anordnung, bei der die Erfindung anwendbar ist,
- Fig. 2: eine Darstellung der verschiedenen Spulen-Anordnungen in bezug auf das Untersuchungsobjekt bzw. den Untersuchungsbereich,
- Fig. 3: ein einzelnes Spulenelement der Referenzspulen-Anordnung,
- Fig. 4: die Einzelheiten eines Blockes in dem Blockschaltbild nach Fig. 1.

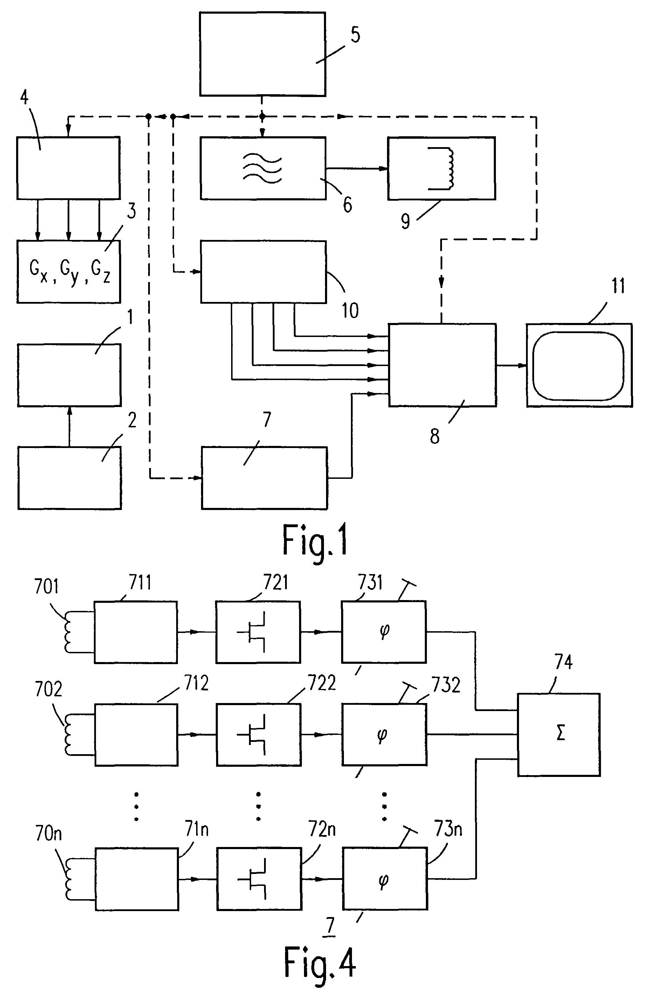

In dem in Fig. 1 schematisch dargestellten Blockschaltbild ist mit 1 ein vorzugsweise supraleitender Magnet bezeichnet, der in einem Untersuchungsbereich, in dem sich ein Patient (Untersuchungsobjekt) befinden kann, ein stationäres homogenes Magnetfeld erzeugt. Der dafür erforderliche Strom wird von einer Einheit 2 geliefert. Mit 3 ist eine Gradientenspulen-Anordnung bezeichnet, mit der ein magnetisches Gradientenfeld erzeugt werden kann, das in Richtung des stationären Magnetfeldes verläuft, und dessen Gradient in der gleichen Richtung, in zwei dazu und zueinander senkrechten Richtungen oder in Richtung eines Vektors verlaufen kann, der sich aus einer Kombination dieser Gradientenfelder ergibt. Die Ströme hierfür werden von einer Treiberschaltung 4 geliefert, wobei der zeitliche Verlauf der Ströme von einer Steuereinheit 5 gesteuert wird, die mittels eines geeigneten Prozessors realisiert werden kann und die auch die anderen Komponenten des MR-Gerätes steuert.

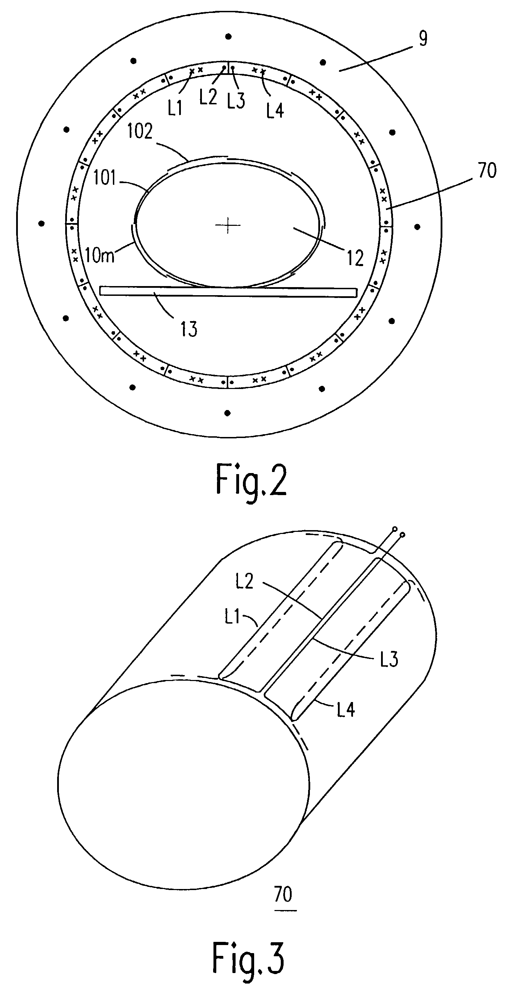

Außerdem ist ein Hochfrequenzgenerator 6 vorgesehen, der impulsweise einen Wechselstrom mit der Larmorfrequenz des Spinsystems erzeugen kann. Diese Ströme werden einer Sendespule 9 zugeführt, die in Fig. 2 in einem zur Richtung des homogenen stationären Magnetfeldes senkrechten Querschnitt dargestellt ist. Die Sendespule 9 kann z.B. vom Bird-Cage-Typ sein und erzeugt im Untersuchungsbereich ein Hochfrequenzmagnetfeld , das senkrecht zur Richtung des homogenen stationären Magnetfeldes verläuft. Die Leiter dieser Sendespule verlaufen senkrecht zu diesem Querschnitt bzw. zur Zeichenebene der Figur 2, so daß sie dort nur als Punkt abgebildet werden.

Die Sendespule 9 umschließt eine Referenzspulen-Anordnung 70, die sich aus einer Anzahl von Spulenelementen zusammensetzt, die gleichmäßig auf dem Umfang eines Kreiszylinders verteilt sind. Die einzelnen Spulenelemente sind vom Butterfly-Typ; eines davon ist in Fig. 3 dargestellt. Ein solches Spulenelement hat zwei Flügel mit den Leitern L1 und L2 bzw. L3 und L4, wobei der Strom durch die in der Mitte liegenden Leiter L2 und L3 in der gleichen Richtung fließt. Daraus resultiert, daß die Ströme in den beiden Flügeln einen entgegengesetzten Umlaufsinn haben, so daß die dadurch senkrecht zu dem einen Flügel erzeugte Magnetfeldkomponente die entgegengesetzt Richtung hat wie die senkrecht zu dem anderen Flügel erzeugte Magnetfeldkomponente. Diese beiden Magnetfeldkomponenten kompensieren sich daher in einigem Abstand von dem betreffenden Spulenelement, so daß nur noch die Magnetfeldkomponenten verbleiben, die parallel zu den Leitern L1 ... L4 (und damit senkrecht zur Zeichenebene der Fig. 2, in der die Leiter der Spulenelemente der Referenzspulen-Anordnung durch Strompfeile - ₓ und ₒ - symbolisiert sind) verlaufen. Das Referenzspulenelement kann also nur Magnetfeldkomponenten erzeugen bzw. empfangen, die parallel zur Richtung der Leiter L1 ... L4 verlaufen.

Mindestens vier Spulenelemente sind erforderlich. Die erforderliche Zahl der Spulenelemente bzw deren Abmessungen in Umfangsrichtung hängen vom Abstand zu dem Spulen-Array ab; je kleiner der Abstand zwischen den Spulenementen der beiden Spulen ist desto mehr bzw kleinere Spulenelemente sind erforderlich. Ein geeigneter Wert ist erreicht, wenn das Signal-/Rauschverhältnis der von dem Spulen-Array gelieferten Signale bei gleichzeitiger Messung mit beiden Spulenanordnungen um weniger als 30% - vorzugsweise um weniger als 5% - abnimmt (im Vergleich zu einer Messung mit dem Spulen-Array und unwirksamer Referenzspulen-Anordnung). Dann besteht zwischen beiden Spulenanordnungen nur noch eine geringe induktive Kopplung.

Die Spulenelemente, aus denen sich die Referenzspulen-Anordnung zusammensetzt, können aus rohrförmigen Leitern bestehen. Sie können jedoch auch leicht durch Ätzen auf einer flexiblen mehrlagigen Platine hergestellt werden, die auf den Träger für die Senderspule 9 aufgebracht wird. Die einzelnen Spulenelemente der Referenzspulen-Anordnung sind so angeordnet, daß sie sich mit den benachbarten Spulenelementen überlappen, wie in Fig. 3 durch die gestrichelten Linien angedeutet. Der Überlappungsgrad ist so gewählt, daß benachbarte Spulenelemente voneinander entkoppelt sind.

Fig. 4 zeigt in einem Blockschaltbild die Spulenelemente 701, 702 ... 70n, aus denen sich die Referenzspulen-Anordnung zusammensetzt und die nachgeschaltete Elektronik. Die Spulensignale werden je über eine Transformationsschaltung 711, 712 ... 71n je einem Vorverstärker 721, 722 ... 72n zugeführt. Die Transformationsschaltungen können so ausgelegt sein, daß sich ein optimales Signal-Rauschverhältnis ergibt. Vorzugsweise sind die Transformationsschaltungen aber so gestaltet, daß sich im Stromkreis der Spulenelemente eine relativ große Impedanz ergibt. so daß der darin als Folge eines MR-Signals fließende Strom reduziert wird, wodurch die Beeinflussung des Spulen-Arrays abnimmt. In diesem Fall wird also nicht in Richtung auf ein maximales Signal-Rauschverhältnis optimiert, sondern auf eine maximale Entkopplung bei einem Signal-Rauschverhältnis, das noch ausreicht, Referenzdaten bzw. ein Referenzbild zu erzeugen. Die Anforderungen an ein solches Referenzbild sind jedoch gering, zumal dieses Bild ein geringes Auflösungsvermögen haben kann, wie aus dem eingangs genannten Dokument bekannt ist.

Die Ausgangssignale der Vorverstärker 731, 732 ... 73n werden über je ein einstellbares bzw. steuerbares Phasendrehglied 731, 732 ... 73n einer gemeinsamen Additionsschaltung 74 zugeführt, deren Ausgangssignal der Summe der Eingangssignale proportional ist. Die aus diesem Ausgangssignal ableitbaren Referenzdaten entsprechen daher den Daten einer einzigen großen, den Untersuchungsbereich umschließenden Spule, deren Empfindlichkeit weitgehend unabhängig von dem im Untersuchungsbereich befindlichen Untersuchungsobjekt ist. Die Referenzspulen-Anordnung und die ihr entsprechend Fig. 4 nachgeschalteten Elektronik ist in Fig. 1 durch den Block 7 angedeutet.

Wie aus Fig. 2 ersichtlich, befindet sich in den von der Referenzspulen-Anordnung umschlossenen Untersuchungsbereich ein Untersuchungsobjekt 12, z.B. ein Patient, auf einer Tischplatte 13 dieser in Längsrichtung senkrecht zur Zeichenebene der Fig. 2 verläuft. Um den Patienten herum ist ein Spulen-Array 10 angeordnet, die aus einer Anzahl von Spulenelementen 101, 102 ... 10m besteht. Diese Spulenelemente sind Oberflächenspulen, mit denen ein zur Spulenfläche senkrechtes Magnetfeld erzeugt bzw. empfangen werden kann. Die von den Spulenelementen der Referenzspulen-Anordnung einerseits und des Spulen-Arrays andererseits erzeugbaren bzw. empfangbaren Magnetfelder stehen also zueinander senkrecht, so daß die beiden Anordnungen weitgehend induktiv voneinander entkoppelt sind. Es können daher mit beiden Spulenanordnungen gleichzeitig MR-Signale empfangen werden, ohne daß das Signal-Rauschverhältnis der von den Spulenelementen des Spulen-Arrays empfangenen MR-Signale in nennenswertem Maße reduziert wird.

Das vom Block 7 gelieferte Signal und die von den einzelnen Spulenelementen des Spulen-Arrays 10 gelieferten MR-Signale werden einer Empfänger- und Verarbeitungseinheit 8 zugeführt, die für jedes Spulenelement des Spulen-Arrays 10 sowie für den Block 7 mit der Referenzspulen-Anordnung einen Kanal enthält, in den das Signal verstärkt, in einen niedrigeren Frequenzbereich transponiert und digitalisiert wird und in dem aus den digitalisierten MR-Signalen Bilddaten eines MR-Bildes bzw. Referenzdaten erzeugt werden kann.

Wie man mit Hilfe der Referenzdaten die Bilddaten so korrigieren kann daß sich die orts- und objektabhängige Empfindlichkeit der Spulenelemente des Spulen-Arrays nicht auf die Bildqualität auswirkt, ist im einzelnen in der eingangs zitierten EP-B 695 947 erläutert, worauf ausdrücklich Bezug genommen wird.

Auch die Empfindlichkeit der Spulenelemente der Referenzspulen-Anordnung ist in einem gewissen Maße ortsabhängig; allerdings wird diese Empfindlichkeit praktisch nicht durch das Untersuchungsobjekt beeinflußt. Bei Bedarf kann man jedoch auch diese Ortsabhängigkeit durch ein Kalibrationsverfahren berücksichtigen, bei dem man mit Hilfe der Referenzspulen-Anordnung ein MR-Bild eines im Untersuchungsbereich angeordneten, vorzugsweise homogenen Phantomkörpers erstellt. Die dabei für verschiedene Punkte des Untersuchungsbereichs rekonstruierten (Referenz-) Daten des MR-Bildes sind der Empfindlichkeit der Referenzspulen-Anordnung in dem betreffenden Punkt direkt proportional. Dieser Empfindlichkeitsverlauf wird gespeichert und dient bei nachfolgenden MR-Untersuchungen eines Objekts mit unbekannter Kernmagnetisierungsverteilung zunächst zur Korrektur der Ortsabhängigkeit der erzeugten Referenzdaten.

Nachdem die Bilddaten des Spulen-Arrays durch die (zuvor gegebenenfalls ihrerseits korrigierten) Referenzdaten korrigiert worden sind: wird das daraus rekonstruierte MR-Bild auf einem Monitor 11 dargestellt.

## Patentansprüche

1. MR-Anordnung umfassend
a) eine Magnetfeldanordnung (1, 2) zur Erzeugung eines homogenen stationären Magnetfeldes in einem Untersuchungsbereich
b) ein Hochfrequenzsystem (6, 9) zur Erzeugung von magnetischen Hochfrequenzimpulsen im Untersuchungsbereich
c) eine Referenzspulen-Anordnung (70) zum Empfang von MR-Signalen aus einem im Untersuchungsbereich befindlichen Objekt
d) eine Verarbeitungseinheit (8) zur Erzeugung von MR-Bildern aus den von den MR-Signalen der Spulenelemente (101,102,.....10n) eines Spulen-Arrays (10) abgeleiteten Bilddaten unter Heranziehung von aus den MR-Signalen der Referenzspulen-Anordnung (70) abgeleiteten Referenzdaten
dadurch gekennzeichnet, daß die Referenzspulen-Anordnung (70) wenigstens vier Spulenelemente (701, 702,.....70n) umfaßt, die in einem zur Richtung des homogenen stationären Magnetfeldes senkrechten Querschnitt gegeneinander versetzt um den Untersuchungsbereich gruppiert sind, und daß die Spulenelemente eine solche Größe haben und derart gestaltet sind, daß sich zwischen dem Spulen-Array (10) und der Referenzspulen-Anordnung (70) nur eine geringe induktive Kopplung ergibt.

2. MR-Anordnung nach Anspruch 1,
dadurch gekennzeichnet, daß die Spulenelemente des Spulen-Arrays (10) einerseits und der Referenzspulen-Anordnung (70) andererseits so gestaltet sind, daß sie um 90° gegeneinander versetzte Magnetfelder empfangen bzw erzeugen können.

3. MR-Anordnung nach Anspruch 2,
dadurch gekennzeichnet, daß die Spulenelemente (701, 702,.....70n) der Referenzspulen-Anordnung vom Butterfly-Typ sind.

4. MR-Anordnung nach einem der vorhergehenden Ansprüche,
dadurch gekennzeichnet, daß die Spulenelemente (701, 702,.....70n) der Referenzspulen-Anordnung (70) gleichmäßig verteilt auf der Mantelfläche eines Zylinders angeordnet sind, dessen Achse parallel zur Richtung des Hauptmagnetfeldes verläuft.

5. MR-Anordnung nach Anspruch 1,
dadurch gekennzeichnet, daß eine Kombinationsschaltung (74) zur Kombination der von den einzelnen Spulenelementen (701, 702,.....70n) der Referenzspulen-Anordnung (70) empfangenen MR-Signale vorgesehen ist.

6. MR-Anordnung nach Anspruch 5,
dadurch gekennzeichnet, daß zwischen den Spulenelementen (701, 702,.....70n) der Referenzspulen-Anordnung und der als Addierschaltung wirksamen Kombinationsschaltung (74) je ein einstellbares Phasendrehglied (731, 732,...73n) wirksam ist.

7. MR-Anordnung nach Anspruch 1,
dadurch gekennzeichnet, daß die Spulenelemente (701, 702,.....70n) der Referenzspulen-Anordnung (70) mit je einem Vorverstärker (721, 722,...72n) über je eine Transformationsschaltung (711, 712,...71n) gekoppelt sind, die so bemessen sind, daß die in den Stromkreis der Spulenelemente (701, 702,.....70n) transformierte Impedanz größer ist als die Impedanz des Spulenelementes.

8. Referenzspulen-Anordnung für ein MR-Gerät mit einer Verarbeitungseinheit (8) zur Erzeugung von MR-Bildern aus den von den MR-Signalen der Spulenelemente (101,102,.....10n) eines Spulen-Arrays (10) abgeleiteten Bilddaten unter Heranziehung von aus den MR-Signalen der Referenzspulen-Anordnung (70) abgeleiteten Referenzdaten
dadurch gekennzeichnet, daß die Referenzspulen-Anordnung (70) wenigstens vier Spulenelemente (701, 702,.....70n) umfaßt, die in einem zur Richtung des homogenen stationären Magnetfeldes senkrechten Querschnitt gegeneinander versetzt um den Untersuchungsbereich gruppiert sind, und daß die Spulenelemente eine solche Größe haben und derart gestaltet sind, daß sich zwischen dem Spulen-Array (10) und der Referenzspulen-Anordnung (70) nur eine geringe induktive Kopplung ergibt.
